(19) Europäisches Patentamt
European Patent Office
Office européen des brevets

(11) **EP 2 120 289 A1**

(12) **EUROPEAN PATENT APPLICATION**

(43) Date of publication:
**18.11.2009 Bulletin 2009/47**

(51) Int Cl.:
***H01Q 7/00*** (2006.01)      ***H01Q 1/38*** (2006.01)
***H01Q 1/32*** (2006.01)

(21) Application number: **08425347.5**

(22) Date of filing: **16.05.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Magneti Marelli S.p.A.**
**20011 Corbetta (MI) (IT)**

(72) Inventor: **Margarita, Alessio**
**10078 Venaria Reale (Torino) (IT)**

(74) Representative: **Notaro, Giancarlo et al**
**c/o Buzzi, Notaro & Antonielli d'Oulx**
**Via Maria Vittoria 18**
**10123 Torino (IT)**

(54) **Antenna apparatus on a printed circuit board**

(57)      An antenna apparatus on printed circuit board is described, including at least one printed circuit board (35), said printed circuit board (35) including a substrate (40) and a first printed metallic track (24; 54) on a first face (37a) of said substrate (40), said first printed metallic track (24; 54) being arranged prevalently along a perimeter of said substrate (40) and being configured as a loop antenna.

According to the invention, such apparatus includes at least one second track (25; 55) obtained on a second face (37b) of said substrate, said second track (25; 55) being arranged prevalently along the perimeter of said substrate (40) and configured as a second turn (23) of said loop antenna to which it is electrically connected by a via-hole (27; 57) provided in said substrate (40) of said printed circuit board (35).

FIG. 2

**Description**

The present invention concerns an antenna apparatus on a printed circuit board, including at least one printed circuit board, said printed circuit board including a substrate and a first printed metallic track on a first face of said substrate, being arranged prevalently along the perimeter of said substrate and configured as a loop antenna.

The majority of current automobiles is equipped with remotely actionable devices, such as door and trunk locks, which can be operated both through a key and through an actuator commanded by a remote control, usually incorporated in the head of the key itself.

For such purpose Printed Circuit Boards (PCB), on which the integrated and/or discrete components are arranged to realise the signal transmission circuit of the remote, are provided with dimensions compatible with the key head.

With the aim of optimising the space on the PCB it is known to realise the antenna of the remote, which is destined to transmit, for example, on the frequency of 433.93 MHz usually reserved for this type of remote control apparatus, by serigraphing the antenna on the PCB in the form of a loop antenna, or frame antenna. In other words, a track is serigraphed on the face of the PCB, being arranged along the perimeter of the PCB. Such loop antenna-forming track usually runs at least along three sides of the PCB and is a metallic track, for example, copper, analogous to the other tracks and pathways connecting the components on the PCB.

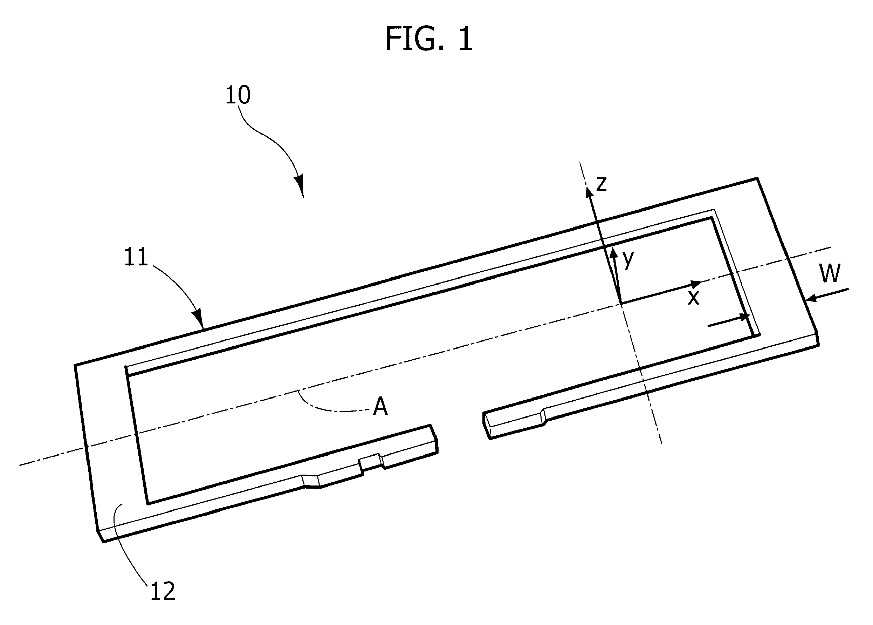

Figure 1 represents a single-track antenna 10 of the type suitable for being implemented on a PCB. Such single-track antenna 10 includes a single coil turn 11, that is, a conductor defining a pathway similar to a closed pathway, obtained by means of a track 12 of printed circuit. As can be observed, the track 12 is a printed pathway, though the PCB is not represented in Figure 1, or more specifically, the substrate of the PCB, on which such track 12 is applied. As is known, the tracks of a printed circuit are usually obtained by applying a layer of copper, for example with a thermal-adhesive glue onto an insulating substrate. Successively, by means of serigraphic techniques, the copper in excess with respect to the design of the tracks for the electrical connections required is removed, for example, through etching with acid, leaving the track on the substrate.

The arrangement of the track at the edges of the PCB, with the other components of the transmitter inside of it, is useful for maximising the area of the loop antenna and for maximising its transmission power.

However, the request for transmission power in such applications is growing, both to improve the quality of the remote opening system, increasing its range and distance, and to reduce the dimensions of automobile key heads while maintaining the same power.

The present invention has the object of realising an antenna apparatus solution on a printed circuit board having greater transmission power while maintaining the same size.

According to the present invention such object is achieved by means of an antenna apparatus having the characteristics specifically recalled in the annexed claims.

The invention will now be described with reference to the annexed drawings, provided by way of nonlimiting example only, wherein:

- Figure 1 has already been described;
- Figure 2 is a schematic representation of an antenna apparatus according to the invention;
- Figure 3 is an exploded view of a key head including an antenna apparatus according to the invention;
- Figures 4a and 4b are detailed views of the antenna apparatus in Figure 3.

In brief, the proposed antenna apparatus on printed circuit board includes a printed circuit board including a substrate and a first metallic printed track, which is arranged prevalently along the perimeter of said substrate and is configured as a first antenna loop. In addition, the printed circuit board includes at least one second track, obtained on a second face of said substrate, which is arranged prevalently along the perimeter of said substrate and is configured as a second turn of said loop antenna connected electrically with said first antenna loop by means of a via-hole provided in said substrate of said printed circuit board.

In this way, a compact two-turn winding is realised, preferably with one turn arranged on each of the two faces of the PCB, increasing the antenna efficiency and, consequently, the transmission power, maintaining however the same PCB size and volume. Furthermore, according to another aspect of the invention, obtaining the second track along a path congruent with that of the first one also simplifies production of the PCB.

The proposed solution provides for an increase in performance of the antenna apparatus in terms of radiated power $P_{RAD}$ with respect to the power lost due to ohmic losses $P_{LOSS}$. Therefore, an explanation of the quantities of interest for the purpose of clarifying the operation and the advantages of the proposed solution will now be introduced herein. Such explanation takes only the radiant part into consideration without considering any matching network, that is, devices apt to maximising the power transferred between source and antenna.

By definition the radiating efficiency of an antenna η is:

$$\eta = \frac{R_{RAD}}{R_{RAD} + R_{LOSS}}$$

where $R_{RAD}$ indicates a radiation resistance of the antenna and $R_{LOSS}$ indicates a loss resistance of the antenna.

Both such resistive terms, $R_{RAD}$ and $R_{LOSS}$, are intrinsic to any real conductor whose antenna impedance $Z_{ANT}$ can be expressed as follows:

$$Z_{ANT} = R_{RAD} + R_{LOSS} + jX_{ANT}$$

where $X_{ANT}$ indicates a reactive component of the antenna.

An antenna loop is not intrinsically resonant as is, for example a dipole, therefore the reactive component $X_{ANT}$ is cancelled by adding an external condenser, called a shunt condenser. In order to increase the efficiency, it is operated so that the radiated power $P_{RAD}$ increases by an amount greater with respect to the power dissipated through losses $P_{LOSS}$, keeping the same antenna current $I_{ANT}$, being:

$$P_{RAD} = R_{RAD} \cdot I_{ANT}^2$$

$$P_{LOSS} = R_{LOSS} \cdot I_{ANT}^2$$

The formulas in closed form allow us to evaluate the two resistive terms $R_{RAD}$ and $R_{LOSS}$, for a multiple-turn loop antenna.

$$R_{RAD} = 31200 \cdot \left( \frac{N \cdot A}{\lambda^2} \right)^2$$

$$R_{LOSS} = \frac{L}{2 \cdot W} \sqrt{\frac{\pi \cdot f_0 \cdot \mu}{\sigma}}$$

where $N$ indicates the number of turns, $A$ the area of the winding turn, $\lambda$ the wavelength of the electromagnetic radiation, $L$ the length of the turn, $W$ the width of the turn, while $\sigma$ indicates the conductivity of the turn and $\mu$ the permeability of the turn.

From the previous expressions it can be inferred that the radiation resistance $R_{RAD}$ depends on the number $N$ of turns according to a quadratic factor, while the resistance loss $R_{LOSS}$ depends linearly on the length $L$ of the turn.

The single-track antenna 10 in Figure 1 will now be considered, wherein the track 12 has a rectangular shape and is realised in copper with conductance values of the turn $\sigma$ and permeability of the turn $\mu$, by way of example, being:

$$\sigma = 5.8 \cdot 10^7 \ \frac{\Omega}{m}$$

$$\mu = 400 \cdot \pi \; \frac{nH}{m}$$

The area $A$ of the turn 11 is 30mm x 25mm and the track 12 has a width $W$ of 2mm.

By applying the relationships and values introduced above the following calculation is obtained for the single-track antenna 10, evaluating the radiation resistance $R_{RAD\_SINGLE}$, the loss resistance $R_{LOSS\_SINGLE}$ and the efficiency $\eta_{SINGLE}$ for the single-track antenna 10:

$$N = 1$$

$$A = 25 \cdot 30 \; mm^2 = 750 \; mm^2 = 750 \; \mu m^2$$

$$L = 2 \cdot 25 + 2 \cdot 30 = 11 \cdot 10^{-2} \; m$$

$$\lambda = \frac{c}{f_0} = \frac{3 \cdot 10^8}{434 \cdot 10^6} = 0.69 \; m$$

$$R_{RAD\_SINGLE} = 31200 \cdot \left( \frac{1 \cdot 750 \cdot 10^{-6}}{0.69^2} \right)^2 = 36 \; m\Omega$$

$$R_{LOSS\_SINGLE} = \frac{11 \cdot 10^{-2}}{2 \cdot 2 \cdot 10^{-3}} \sqrt{\frac{3.14 \cdot 434 \cdot 10^8 \cdot 400 \cdot 3.14 \cdot 10^{-9}}{5.8 \cdot 10^7}} = 0.15 \; \Omega$$

$$\eta_{SINGLE} = \frac{0.036}{0.036 + 0.15} = 0.19$$

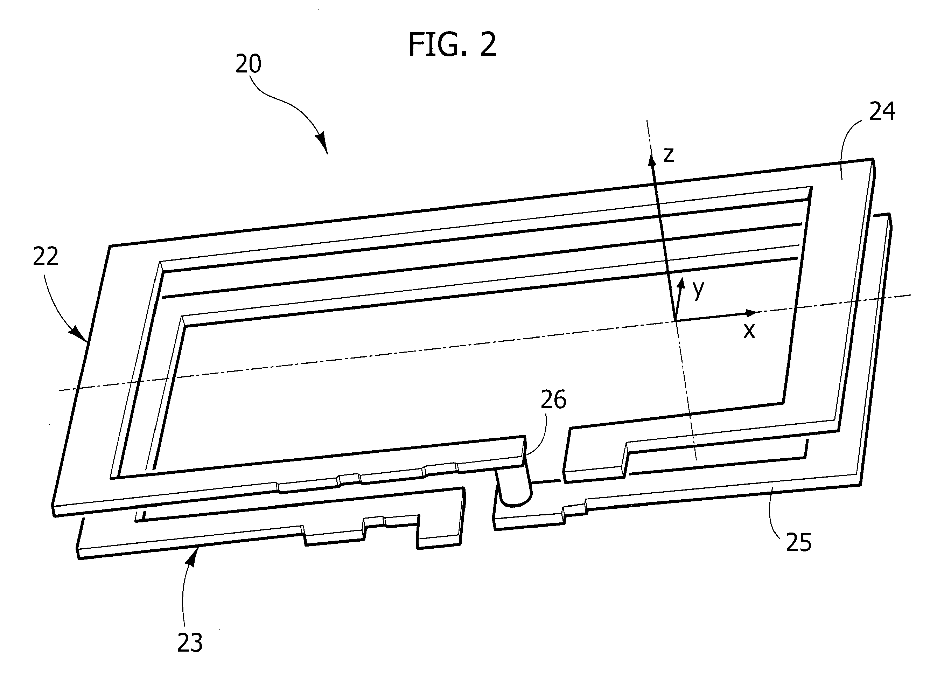

Instead, Figure 2 shows a double-track antenna 20 according to the invention, including a coil or winding 21 itself including two winding turns 22 and 23. Such turns 22 and 23 are realised through respective tracks 24 and 25 with dimensions completely analogous to those indicated for the track 12, which realises the turn 11 in Figure 1. The tracks 24 and 25 are electrically interconnected by means of an interconnecting path 26. In Figure 2, as was seen in Figure 1, orientation axes x, y, z are indicated, making evident how the first perimetral track 24 lies in a plane substantially parallel to the plane in which the second perimetral track 25 lies.

Therefore, by applying the same calculation previously applied to the single-track antenna 10 to the double-track antenna 20, the following calculations can be developed:

$$N = 2$$

$$A = 25 \cdot 30 \; mm^2 = 750 \; mm^2 = 750 \; \mu m^2$$

$$L = (2 \cdot 25 + 2 \cdot 30) \cdot 2 = 22 \cdot 10^{-2} \; m$$

$$\lambda = \frac{c}{f_0} = \frac{3 \cdot 10^8}{434 \cdot 10^6} = 0.69 \; m$$

$$R_{RAD\_DOUBLE} = 31200 \cdot \left( \frac{2 \cdot 750 \cdot 10^{-6}}{0.69^2} \right)^2 = 147 \; m\Omega$$

$$R_{LOSS\_DOUBLE} = \frac{22 \cdot 10^{-2}}{2 \cdot 2 \cdot 10^{-3}} \sqrt{\frac{3.14 \cdot 434 \cdot 10^6 \cdot 400 \cdot 3.14 \cdot 10^{-9}}{5.8 \cdot 10^7}} = 0.30 \; \Omega$$

$$\eta_{DOUBLE} = \frac{0.147}{0.147 + 0.30} = 0.33$$

Therefore, the efficiency $\eta_{DOUBLE}$ of the double-track antenna 20 is considerably greater with respect to the efficiency $\eta_{SINGLE}$ of the single-track antenna 10.

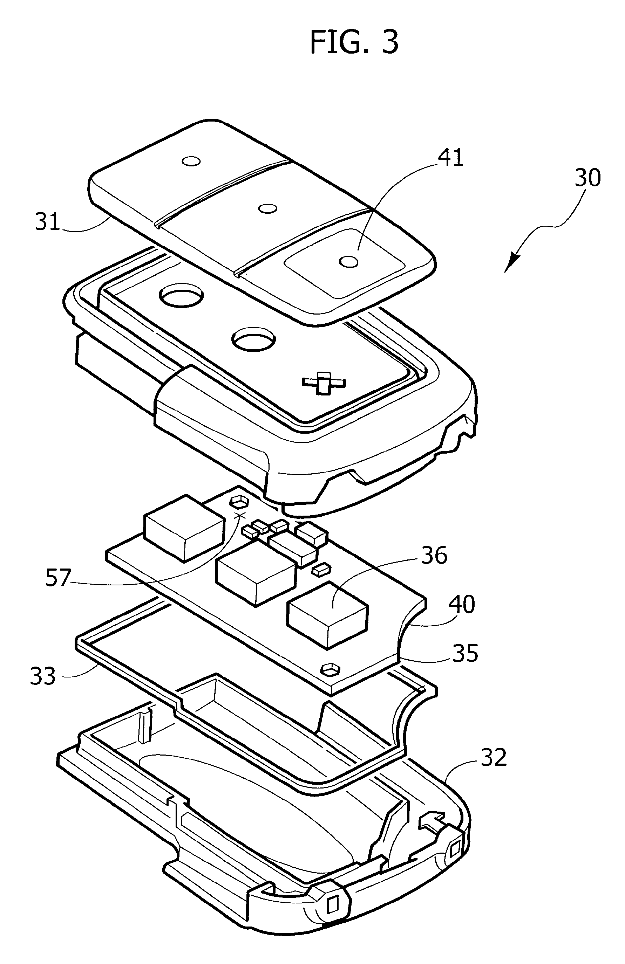

In Figure 2, the double-track antenna 20 is also schematically represented without showing the PCB on which the turns 22 and 23 are applied, however it can be appreciated how such turns 22 and 23, that is, the corresponding tracks 24 and 25, are connected together through an interconnecting path 26, which is destined to pass through a suitable via-hole provided in the PCB. As will be illustrated better with reference to Figure 3, the turns 22 and 23 are thus arranged on the two faces of a PCB electrically connected by means of such interconnecting path 26.

Figure 3 shows in greater detail an embodiment 50 of the double-track antenna 20 in Figure 2. Thus Figure 3 shows an exploded view of an automotive key head, indicated in its entirety with reference 30, including an upper half-body 31 and a lower half-body 32, destined, along with an interposed rubber gasket 33 for sealing purposes, to be coupled together to house the PCB 35 inside of them. Such PCB 35 includes a plurality of electronic components 36, both discrete components such as resistors or condensers, or integrated circuits such as amplifiers, arranged on a substrate 40, which realise a signal transmission circuit on a printed circuit board.

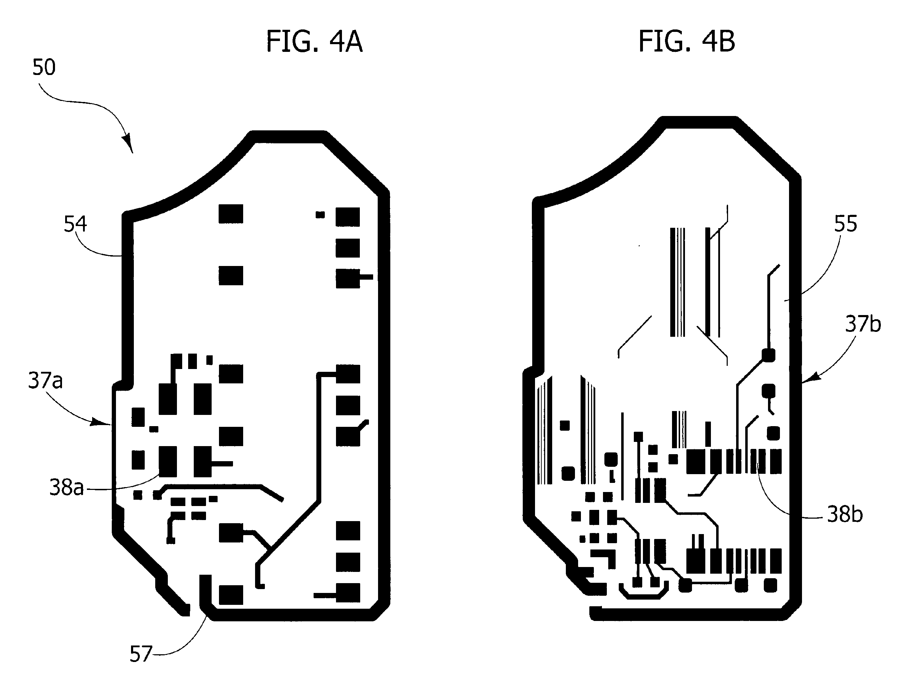

Figures 4a and 4b represent in plan views of a first upper face 37a of such PCB 35 having serigraphed first electrical connection tracks 38a for such electronic components 36, and of a second face 37b of such PCB 35 having serigraphed second electrical connection tracks 38b, respectively. As can be noted in Figure 3, both the first face 37a and the second face 37b have perimetral tracks 54 and 55 that substantially correspond to the tracks 24 and 25 of Figure 2. However, such perimetral tracks 54 and 55, although having a substantially rectangular arrangement, preferentially tend to follow the perimeter of the substrate 40, rectangular, but having a pattern adapted to the shape of the housing defined by the half-bodies 31 and 32. In any case, such perimetral tracks 54 and 55 have an arrangement substantially congruent with each other and are connected in correspondence with the through-hole 57.

Naturally, without prejudice to the underlying principle of the invention, the details and the embodiments may vary, even appreciably, with respect to what has been described and illustrated by way of example only, without departing from the scope of the present invention.

**Claims**

1.  An antenna apparatus on a printed circuit board, including at least one printed circuit board (35), said printed circuit board (35) including a substrate (40) and a first printed metallic track (24; 54) on a first face (37a) of said substrate (40), said first printed metallic track (24; 54) being arranged prevalently along a perimeter of said substrate (40) and being configured as a loop antenna,
    **characterised in that**
    it includes at least a second track (25; 55) obtained on a second face (37b) of said substrate, said second track (25; 55) being arranged prevalently along the perimeter of said substrate (40) and configured as a second turn (23) of said loop antenna to which it is electrically connected by a viua-hole (27; 57) provided in said substrate (40) of said printed circuit board (35).

2.  An apparatus according to claim 1, **characterised in that** said second track (25; 55) arranged prevalently along the perimeter of said substrate (40) is substantially congruent with said first track (24; 54) arranged prevalently along the perimeter of said substrate (40).

3.  An apparatus according to claim 2, **characterised in that** said second track (25; 55) lies in a plane substantially parallel to the plane in which said first track (24; 54) lies.

4.  An apparatus according to one or more of the previous claims, **characterised in that** said first track (24; 54) and said second track (25; 55) have a substantially rectangular shape.

5.  An apparatus according to one or more of the previous claims, **characterised in that** it is operatively associated with a signal transmission circuit (36) arranged on said PCB (35).

6.  An apparatus according to one or more of the previous claims, **characterised in that** it is included in a remote control device (30) for actuators.

7.  An apparatus according to the previous claim, **characterised in that** it is included in a body (31, 32) being part of an automobile key.

FIG. 1

EP 2 120 289 A1

# FIG. 2

EP 2 120 289 A1

FIG. 3

FIG. 4B

FIG. 4A

**European Patent
Office**

**EUROPEAN SEARCH REPORT**

Application Number

EP 08 42 5347

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/081808 A (3M INNOVATIVE PROPERTIES CO [US]) 9 September 2005 (2005-09-09) * abstract; figures 3,4 * * paragraphs [0036] - [0041] * ----- | 1,3-7 | INV. H01Q7/00 H01Q1/38 H01Q1/32 |
| X | EP 1 217 685 A (MATSUSHITA ELECTRIC IND CO LTD [JP]) 26 June 2002 (2002-06-26) * figure 7 * * paragraphs [0026] - [0030] * ----- | 1-7 | |
| A | EP 0 674 354 A (HOCHIKI CO [JP]) 27 September 1995 (1995-09-27) * abstract; figure 5 * * column 9, line 17 - column 10, line 6 * ----- | 1-7 | |
| A | US 2007/241986 A1 (LEE SUNG-JUN [KR] ET AL) 18 October 2007 (2007-10-18) * abstract; figures 1,2 * * paragraphs [0026] - [0033] * ----- | 1-7 | |
| | | | TECHNICAL FIELDS SEARCHED (IPC) H01Q |

The present search report has been drawn up for all claims

| Place of search | Date of completion of the search | Examiner |
|---|---|---|
| Munich | 29 September 2008 | Unterberger, Michael |

EPO FORM 1503 03.82 (P04C01)

## ANNEX TO THE EUROPEAN SEARCH REPORT
## ON EUROPEAN PATENT APPLICATION NO.

EP 08 42 5347

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2008

| Patent document cited in search report | | Publication date | Patent family member(s) | | Publication date |
|---|---|---|---|---|---|
| WO 2005081808 | A | 09-09-2005 | AR | 047688 A1 | 01-02-2006 |
| | | | AU | 2005215971 A1 | 09-09-2005 |
| | | | BR | PI0507832 A | 10-07-2007 |
| | | | CA | 2557453 A1 | 09-09-2005 |
| | | | CN | 1934576 A | 21-03-2007 |
| | | | EP | 1733332 A1 | 20-12-2006 |
| | | | JP | 2007523562 T | 16-08-2007 |
| | | | KR | 20060131905 A | 20-12-2006 |
| | | | NZ | 549371 A | 28-03-2008 |
| | | | US | 2004183742 A1 | 23-09-2004 |
| EP 1217685 | A | 26-06-2002 | CN | 1359167 A | 17-07-2002 |
| | | | DE | 60113788 T2 | 10-08-2006 |
| | | | KR | 20020046952 A | 21-06-2002 |
| | | | US | 2002089461 A1 | 11-07-2002 |
| EP 0674354 | A | 27-09-1995 | DE | 69509961 D1 | 08-07-1999 |
| | | | DE | 69509961 T2 | 07-10-1999 |
| | | | JP | 7263935 A | 13-10-1995 |
| US 2007241986 | A1 | 18-10-2007 | NONE | | |

EPO FORM P0459

For more details about this annex : see Official Journal of the European Patent Office, No. 12/82